# FASCICULE DE BREVET EUROPEEN

(11) **EP 3 141 966 B1**
(45) Date de publication et mention de la délivrance du brevet: **09.05.2018**
(21) Numéro de dépôt: 15184187.1
(22) Date de dépôt: 08.09.2015
(51) Int. Cl.: G04B 19/10, G04B 19/12, G04B 45/00

(54) **PROCEDE DE FORMATION D'UNE SURFACE DECORATIVE SUR UNE PIECE MICROMECANIQUE HORLOGERE ET LADITE PIECE MICROMECANIQUE HORLOGERE**
ERZEUGUNGSVERFAHREN EINER DEKOROBERFLÄCHE EINES MIKROMECHANISCHEN UHRENBAUTEILS, UND ENTSPRECHENDES MIKROMECHANISCHES UHRENBAUTEIL
METHOD FOR FORMING A DECORATIVE SURFACE ON A MICROMECHANICAL TIMEPIECE PART AND SAID MICROMECHANICAL TIMEPIECE PART

(43) Date de publication de la demande: 15.03.2017
(73) Titulaire: Nivarox-FAR S.A., 2400 Le Locle (CH)
(72) Inventeur: Dubois, Philippe, 2074 Marin (CH)
(74) Mandataire: Honoré, Anne-Claire

(56) Documents cités:
- EP-A1- 1 722 281
- EP-A1- 3 035 128
- US-A- 4 599 251
- TJERKSTRA R W ET AL: "ELECTROCHEMICAL FABRICATION OF MULTI WALLED MICRO CHANNELS", MICRO TOTAL ANALYSIS SYSTEMS. PROCEEDINGS OF THE UTAS WORKSHOP, XX, XX, 13 octobre 1998 (1998-10-13), pages 133-136, XP000874456,

## Description

### Domaine de l'invention

La présente invention se rapporte à un procédé pour réaliser une surface décorative sur une pièce micromécanique horlogère comprenant un substrat à base de silicium. L'invention se rapporte également à une pièce micromécanique horlogère comprenant une telle surface décorative, pouvant notamment être obtenue par un tel procédé.

### Arrière-plan de l'invention

Le silicium est un matériau de plus en plus utilisé dans la fabrication de pièces micromécaniques horlogères, notamment des pièces qui restent liées à un substrat à base de silicium sur lequel elles ont été usinées.

Par exemple, des substrats à base de silicium peuvent être utilisés pour réaliser des cadrans.

Les cadrans des montres ou autre pièce d'horlogerie comportent des inscriptions ou des surfaces décoratives permettant de donner des indications ou de mettre en valeur le cadran. Ces décorations sont traditionnellement réalisées par différentes techniques de gravure.

Le brevet US 4,599,251 décrit un procédé de décoration d'un article par traitement d'un élément de silicium.

Le document EP-A-3035128 est compris dans l'état de la technique selon l'article 54.3 CBE et décrit un procédé de formation d'une surface décorative sur une pièce micromécanique horlogère comportant un substrat en silicium poreux. La surface dudit substrat à base de silicium poreux ne corresponde pas à la zone décorative à former par usinage micromécanique. Il n'est pas mentionné si la zone décorative montre une surface poreuse après l'usinage. Lorsque le cadran est réalisé à base de silicium, il est nécessaire de proposer de nouvelles techniques pour réaliser de telles inscriptions ou de surfaces décoratives, faciles à mettre en oeuvre.

### Résumé de l'invention

A cet effet, la présente invention concerne un procédé de formation d'une surface décorative sur une pièce micromécanique horlogère comprenant un substrat à base de silicium.

Selon l'invention, ledit procédé comprend au moins une étape a) de formation de pores à la surface dudit substrat à base de silicium sur une zone du substrat à base de silicium correspondant à la surface décorative à former, lesdits pores étant agencés pour déboucher à la surface externe de la pièce micromécanique horlogère.

La présente invention concerne également une pièce micromécanique horlogère susceptible d'être obtenue par le procédé tel que défini ci-dessus.

La présente invention concerne également une pièce micromécanique horlogère comprenant un substrat à base de silicium, et présentant, sur au moins une zone dudit substrat à base de silicium, des pores formés dans ladite zone du substrat à base de silicium et débouchant à la surface externe de la pièce micromécanique horlogère pour former une surface décorative sur ladite zone.

Le procédé selon l'invention permet de créer sur la pièce micromécanique horlogère une surface de silicium poreux décorative de couleur très foncée, proche du noir. Un revêtement métallisé appliqué sur le silicium poreux permet d'obtenir une surface décorative de couleurs interférentielles.

### Brève description des dessins

Les buts, avantages et caractéristiques de la présente invention apparaîtront plus clairement dans la description détaillée suivante d'au moins une forme de réalisation de l'invention donnée uniquement à titre d'exemple non limitatif et illustrée par les dessins annexés sur lesquels :

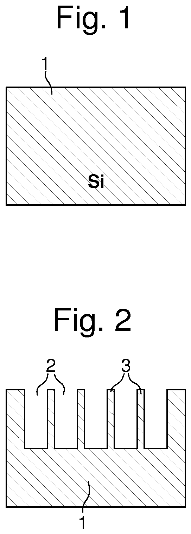

- les figures 1 à 2 illustrent schématiquement les étapes d'un procédé selon l'invention.

### Description détaillée de l'invention

En référence aux figures 1 et 2, le procédé de formation d'une surface décorative sur une pièce micromécanique horlogère comprenant un substrat à base de silicium 1 selon l'invention comprend tout d'abord une étape a) de formation de pores 2 à partir de la surface dudit substrat à base de silicium 1 sur une zone du substrat à base de silicium 1 correspondant à la surface décorative à former. Les pores 2 sont agencés de manière à déboucher à la surface externe de la pièce micromécanique horlogère, afin de former une surface visible pour l'utilisateur. Le substrat à base de silicium 1 est choisi en fonction de la pièce micromécanique horlogère à former. La forme finale du substrat à base de silicium en fonction de la pièce micromécanique horlogère à fabriquer est donnée avant ou après la mise en oeuvre du procédé de l'invention. Dans la présente invention, l'expression « substrat à base de silicium » désigne aussi bien une couche de silicium dans un substrat qu'un substrat en silicium. De préférence, le substrat à base de silicium 1 est un wafer de silicium ou un wafer SOI (Silicon-on-Insulator).

D'une manière avantageuse, cette étape a) peut être réalisée par un procédé choisi parmi le groupe comprenant un procédé par attaque électrochimique, un procédé de type « Stain-etch », et un procédé de type « MAC-Etch ».

Le procédé par attaque électrochimique peut être un procédé par anodisation électrochimique. Sa mise en oeuvre nécessite l'utilisation d'un bain électrochimique contenant de l'acide fluorhydrique en solution aqueuse ou mélangé à de l'éthanol dans des concentrations de 1 à 10%. Un courant électrique et des électrodes sont nécessaires pour créer des conditions électrochimiques induisant l'attaque du silicium. Selon les conditions électrochimiques, différents types de pores peuvent être obtenus. Un tel procédé est connu de l'homme du métier et ne nécessite pas d'informations détaillées ici.

Le procédé de type « Stain-etch » est basé sur une attaque humide du silicium aboutissant directement à la formation de silicium poreux. Typiquement, l'attaque se fait avec une solution HF/HNO₃/H₂O avec un rapport HF:HNO₃ de 50-500:1. Ce procédé présente l'avantage de ne pas nécessiter d'apport électrique dans le bain. Un tel procédé est connu de l'homme du métier et ne nécessite pas d'informations détaillées ici.

De préférence, l'étape a) est réalisée par un procédé de type « MAC-Etch ». Ce procédé est basé sur l'utilisation de particules de métaux nobles pour catalyser des réactions d'attaques chimiques locales. Typiquement, une couche très mince (10-50 nm) d'un métal noble (or, argent, platine) est déposée et structurée de manière aléatoire ou par lift-off, attaque, laser, etc. De préférence, le métal noble est de l'or. Plus particulièrement, on peut utiliser avantageusement des particules d'or en solution dans un mélange HF/H₂O₂. La taille des particules peut être comprise entre 5 et 1000 nm. La structuration peut être obtenue par lithographie de l'or, attaque ou lift-off. Une autre option est l'évaporation ou la pulvérisation cathodique (sputtering) d'une couche très fine non fermée (5-30 nm). Un traitement thermique pourra contribuer à la formation d'ilots d'or.

Lorsque le silicium avec la couche de métal noble est plongé dans une solution aqueuse d'un mélange HF/H₂O₂, le métal noble catalyse localement la dissolution du silicium. Cette solution d'attaque peut comprendre typiquement entre 4 ml : 1 ml : 8 ml (48% HF : 30% H₂O₂ : H₂O) et 4 ml : 1 ml : 40 ml (48% HF : 30% H₂O₂ : H₂O). La dissolution du silicium se produit préférentiellement sous le métal, celui-ci s'enfonçant alors progressivement dans le silicium. Cette réaction peut se poursuivre sur de grandes profondeurs (> 100 mµ) selon des modes de propagation essentiellement influencés par l'orientation du cristal de silicium, la disposition des surfaces, le dopage et la chimie du bain. Le procédé de type « MAC-Etch » présente l'avantage de ne pas nécessiter d'apport électrique dans le bain tout en autorisant la formation de pores de très grande profondeur (> 100 mµ) dans le silicium. Il est donc particulièrement adapté à l'utilisation, en tant que substrat, de wafers SOI généralement utilisés pour la fabrication des composants horlogers.

L'homme du métier connait les paramètres des procédés décrits ci-dessus à mettre en oeuvre pour que les pores formés dans le substrat à base de silicium présentent une géométrie et une taille appropriées.

Notamment, en assimilant les pores, dans le plan de la pièce, à des orifices de section circulaire, lesdits pores peuvent présenter de préférence un diamètre compris entre 10 nm et 1000 nm.

Avantageusement, les pores peuvent présenter une profondeur supérieure à 100 nm, de préférence comprise entre 100 nm et 10 µm, et plus préférentiellement comprise entre 100 nm et 3 µm.

La géométrie et la taille appropriées des pores permettent d'obtenir une zone de silicium poreux présentant un très haut pouvoir d'absorption de la lumière, dans le domaine du visible notamment, et anti-reflets. On obtient en conséquence une zone de couleur très foncée, sensiblement noire. Comme représenté sur la figure 2, la formation de pores 2 dans le substrat à base de silicium 1 sur une certaine profondeur entraine la formation, entre les pores 2, de piliers 3 à base de silicium sur la même profondeur. De préférence, en considérant les piliers à base de silicium comme ayant une section circulaire, les pores 2 sont formés de sorte que la surface projetée des piliers 3 à base de silicium est inférieure à 79% de la surface totale apparente afin de ne pas avoir de piliers à base de silicium qui se touchent. La zone de couleur obtenue est utilisée comme surface décorative sur la pièce micromécanique horlogère. Par surface décorative, on entend par exemple un dessin, un motif ou une inscription, telle que des chiffres, ou tout autre décor.

Le procédé selon l'invention peut optionnellement comprendre, après l'étape a), une deuxième étape b) consistant à déposer au moins un revêtement sur la surface décorative en silicium poreux obtenue selon l'étape a).

Avantageusement, ce revêtement déposé à l'étape b) peut comprendre une couche de métallisation à base d'au moins l'un des éléments choisis parmi le groupe comprenant Cr, Ti, Ag, Pt, Cu, Ni, Pd, Rh. De préférence, la couche de métallisation est une fine couche, d'épaisseur inférieure à 50 nm.

Avantageusement, le revêtement déposé à l'étape b) peut comprendre également une couche transparente d'oxyde, tel que l'un des oxydes choisis parmi le groupe comprenant SiO₂, TiO₂, ZrO₂, HfO₂, Ta₂O₅, VO₂, ou leurs mélanges. La couche de métallisation ou la couche d'oxyde peuvent être utilisées seules, et être déposées par exemple directement sur le Si poreux, ou les deux couches peuvent être associées, la couche d'oxyde recouvrant alors la couche de métallisation. L'épaisseur de la couche d'oxyde est de préférence comprise entre 100 nm et 2000 nm.

Le revêtement d'une couche de métallisation et d'une couche transparente d'oxyde sur la surface décorative en silicium poreux permet d'obtenir une surface décorative de couleurs interférentielles.

Le procédé selon l'invention peut avantageusement être mis en oeuvre pour la fabrication de pièces à base de silicium, telles que les cadrans.

La présente invention concerne également une pièce micromécanique horlogère susceptible d'être obtenue par le procédé tel que décrit ci-dessus.

Notamment, la présente invention concerne une pièce micromécanique horlogère comprenant un substrat à base de silicium 1, et présentant, sur au moins une zone dudit substrat à base de silicium 1, des pores 2 formés dans ladite zone du substrat à base de silicium 1 et débouchant à la surface externe de la pièce micromécanique horlogère pour former une surface décorative sur ladite zone, de couleur très foncée, comme décrit ci-dessus.

Selon une autre variante de réalisation, la surface décorative de silicium poreux est recouverte d'un revêtement comprenant une couche de métallisation à base d'au moins l'un des éléments choisis parmi le groupe comprenant Cr, Ti, Ag, Pt, Cu, Ni, Pd, Rh.

Selon une autre variante de réalisation, la surface décorative de silicium poreux est recouverte d'un revêtement comprenant une couche transparente d'oxyde choisi parmi le groupe comprenant SiO₂, TiO₂, ZrO₂, HfO₂, Ta₂O₅, VO₂.

D'une manière avantageuse, la surface décorative de silicium poreux est recouverte d'un revêtement comprenant la couche de métallisation recouverte de la couche transparente d'oxyde. Cela permet de former une surface décorative de couleurs interférentielles.

## Revendications

1. Procédé de formation d'une surface décorative sur une pièce micromécanique horlogère comprenant un substrat à base de silicium (1), **caractérisé en ce que** ledit procédé comprend au moins une étape a) de formation de pores (2) à la surface dudit substrat à base de silicium (1) sur une zone du substrat à base de silicium (1) correspondant à la surface décorative à former, lesdits pores étant agencés pour déboucher à la surface externe de la pièce micromécanique horlogère.

2. Procédé selon la revendication 1, **caractérisé en ce qu'**il comprend, après l'étape a), une étape b) de dépôt d'au moins un revêtement sur la surface décorative.

3. Procédé selon la revendication 2, **caractérisé en ce que** le revêtement comprend une couche de métallisation.

4. Procédé selon l'une des revendications 2 et 3, **caractérisé en ce que** le revêtement comprend une couche transparente d'oxyde choisi parmi le groupe comprenant SiO₂, TiO₂, ZrO₂, HfO₂, Ta₂O₅, VO₂.

5. Procédé selon l'une des revendications 1 à 4, dans lequel l'étape a) est réalisée par un procédé choisi parmi le groupe comprenant un procédé par attaque électrochimique, un procédé de type « Stain-etch », et un procédé de type « MAC-Etch ».

6. Procédé selon la revendication 5, dans lequel l'étape a) est réalisée par un procédé de type « MAC-Etch ».

7. Procédé selon l'une des revendications précédentes, dans lequel les pores sont assimilés, dans le plan de la pièce, à des orifices de section circulaire et présentent un diamètre compris entre 10 nm et 1000 nm.

8. Procédé selon l'une des revendications précédentes, dans lequel les pores (2) présentent une profondeur supérieure à 100 nm.

9. Procédé selon l'une des revendications précédentes, dans lequel le substrat à base de silicium (1) est un wafer de silicium ou un wafer SOI (Silicon-on-Insulator).

10. Pièce micromécanique horlogère comprenant un substrat à base de silicium (1), **caractérisée en ce qu'**elle présente, sur au moins une zone dudit substrat à base de silicium (1), des pores (2) formés dans ladite zone du substrat à base de silicium (1) et débouchant à la surface externe de la pièce micromécanique horlogère pour former une surface décorative sur ladite zone.

11. Pièce micromécanique horlogère selon la revendication 10, **caractérisée en ce que** la surface décorative est recouverte d'un revêtement comprenant une couche de métallisation et/ou une couche transparente d'oxyde choisi parmi le groupe comprenant SiO₂, TiO₂, ZrO₂, HfO₂, Ta₂O₅, VO₂.

## Patentansprüche

1. Verfahren zum Bilden einer Zieroberfläche eines mikromechanischen Uhrenteils, das ein Substrat (1) auf Siliciumbasis umfasst, **dadurch gekennzeichnet, dass** das Verfahren mindestens einen Schritt a) des Bildens von Poren (2) in der Oberfläche des Substrats (1) auf Siliciumbasis in einem Bereich des Substrats (1) auf Siliciumbasis, der der zu bildenden Zieroberfläche entspricht, umfasst, wobei die Poren so angeordnet sind, dass sie in die äußere Oberfläche des mikromechanischen Uhrenteils münden.

2. Verfahren nach Anspruch 1, **dadurch gekennzeichnet, dass** es nach dem Schritt a) einen Schritt b) des Ablagerns mindestens einer Beschichtung auf der Zieroberfläche umfasst.

3. Verfahren nach Anspruch 2, **dadurch gekennzeichnet, dass** die Beschichtung eine Metallisierungsschicht umfasst.

4. Verfahren nach einem der Ansprüche 2 und 3, **dadurch gekennzeichnet, dass** die Beschichtung eine lichtdurchlässige Oxidschicht umfasst, die aus der Gruppe gewählt ist, die SiO₂, TiO₂, ZrO₂, HfO₂, Ta₂O₅ und VO₂ enthält.

5. Verfahren nach einem der Ansprüche 1 bis 4, wobei der Schritt a) durch ein Verfahren ausgeführt wird, das aus der Gruppe gewählt ist, die ein Verfahren durch elektrochemische Ätzung, ein Verfahren des Typs "Stain-Etch" und ein Verfahren des Typs "MAC-Etch" umfasst.

6. Verfahren nach Anspruch 5, wobei der Schritt a) durch ein Verfahren des Typs "MAC-Etch" ausgeführt wird.

7. Verfahren nach einem der vorhergehenden Ansprüche, wobei die Poren in der Ebene des Teils in Öffnungen mit kreisförmigem Querschnitt aufgenommen sind, die einen Durchmesser im Bereich von 10 nm bis 1000 nm aufweisen.

8. Verfahren nach einem der vorhergehenden Ansprüche, wobei die Poren (2) eine Tiefe von mehr als 100 nm aufweisen.

9. Verfahren nach einem der vorhergehenden Ansprüche, wobei das Substrat (1) auf Siliciumbasis ein Silicium-Wafer oder ein SOI (Silicon-on-Insulator)-Wafer ist.

10. Mikromechanisches Uhrenteil, umfassend ein Substrat (1) auf Siliciumbasis, **dadurch gekennzeichnet, dass** es mindestens in einem Bereich des Substrats (1) auf Siliciumbasis Poren (2) aufweist, die in dem Bereich des Substrats (1) auf Siliciumbasis gebildet sind und in die äußere Oberfläche des mikromechanischen Uhrenteils münden, um in dem Bereich eine Zieroberfläche zu bilden.

11. Mikromechanisches Uhrenteil nach Anspruch 10, **dadurch gekennzeichnet, dass** die Zieroberfläche mit einer Beschichtung beschichtet ist, die eine Metallisierungsschicht und/oder eine lichtdurchlässige Oxidschicht umfasst, die aus der Gruppe gewählt ist, die SiO₂, TiO₂, ZrO₂, HfO₂, Ta₂O₅ und VO₂ enthält.

## Claims

1. Method of forming a decorative surface on a micromechanical timepiece part comprising a silicon-based substrate (1), **characterised in that** said method comprises at least one step a) of forming pores (2) on the surface of said silicon-based substrate (1) over a zone of the silicon-based substrate (1) which corresponds to the decorative surface to be formed, said pores being designed to open out at the external surface of the micromechanical timepiece part.

2. Method according to claim 1, **characterised in that** it comprises, after step a), a step b) of depositing at least one coating on the decorative surface.

3. Method according to claim 2, **characterised in that** the coating comprises a metallisation layer.

4. Method according to one of the claims 2 and 3, **characterised in that** the coating comprises a transparent oxide layer chosen from the group comprising SiO₂, TiO₂, ZrO₂, HfO₂, Ta₂O₅, VO₂.

5. Method according to one of the claims 1 to 4, wherein step a) is achieved by a method chosen from the group comprising a method by electrochemical etching, a method of the « Stain-etch » type and a method of the « Mac-Etch » type .

6. Method according to claim 5, wherein step a) is achieved by a method of the « MAC-Etch » type.

7. Method according to one of the preceding claims, wherein the pores are assimilated, in the plane of the timepiece part, with orifices of circular section, and have a diameter between 10 nm and 1,000 nm.

8. Method according to one of the preceding claims, wherein the pores (2) have a depth greater than 100 nm.

9. Method according to one of the preceding claims, wherein the silicon-based substrate (1) is a silicon wafer or an SIO wafer (Silicon-on-Insulator).

10. Micromechanical timepiece part comprising a silicon-based substrate (1), **characterised in that** it has, over at least one zone of said silicon-based substrate (1), pores (2) which are formed in said zone of the silicon-based substrate (1) and open out at the external surface of the micromechanical timepiece part in order to form a decorative surface over said zone.

11. Micromechanical timepiece part according to claim 10, **characterised in that** the decorative surface is covered by a coating comprising a metallisation layer and/or a transparent oxide layer chosen from the group comprising SiO₂, TiO₂, ZrO₂, HfO₂, Ta₂O₅, VO₂.
